(19) Europäisches Patentamt

European Patent Office

Office européen des brevets

(11) **EP 1 353 272 A2**

(12) **EUROPEAN PATENT APPLICATION**

(43) Date of publication:
**15.10.2003 Bulletin 2003/42**

(51) Int Cl.[7]: **G06F 11/10**, G06F 5/00

(21) Application number: **03251262.6**

(22) Date of filing: **03.03.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **28.03.2002 GB 0207492**

(71) Applicant: **MATSUSHITA ELECTRIC INDUSTRIAL CO., LTD.**
**Kadoma-shi, Osaka 571 (JP)**

(72) Inventor: **Kuang, Wen Tao**
**Thatcham, Berkshire RG19 4ZD (GB)**

(74) Representative: **Dawson, Elizabeth Ann et al**
**A.A. Thornton & Co.**
**235 High Holborn**
**London WC1V 7LE (GB)**

(54) **Improved carryout word calculation for cyclic shift registers**

(57) A method of calculating the carry out word from a shift register such as a CRC encoder, decoder or error trapping circuit having feedback taps at positions determined by a generator polynomial, in which the carryout word of length K is calculated from the formula:

$$carryout\_word = select\_word.top\_word\_matrix$$

carryout_word being a 1 x K row vector, top_word_matrix being calculated from the top K bits of the shift register, and select_word being a 1 x K row vector determined from the generator polynomial.

Figure 2. Bit-wise CRC calculation for example 1

## Description

The present invention relates to carryout word calculation for cyclic shift registers such as CRC encoder, decoder and error trapping circuits.

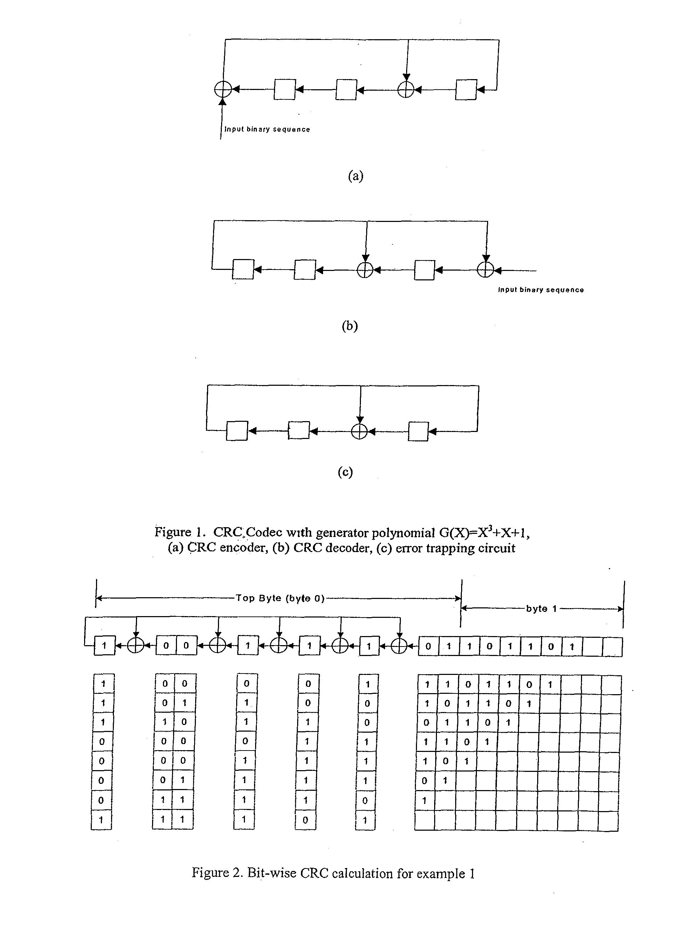

Figures 1(a), 1(b) and 1(c) show examples of CRC encoder, decoder and error trapping circuits. The positions of the feedback taps are determined by the generator polynomial corresponding to the code.

Thus, figure 1 shows a CRC codec with generator polynomial

$$G(X) = X^3 + X + 1$$

Figure 1(a) showing the CRC encoder and figure 1(b) the decoder. In the traditional operation of these circuits, the contents of the shift register (known as parity bits for encoder and syndrome for decoder) are shifted in a bit-wise manner.

It has been proposed to shift the content of the shift register for syndrome calculation byte-by-byte instead of bit-by-bit. This is described in an article by Jack Crenshaw in Embedded Systems Programming, January 1992, pages 34-40.

In our copending (unpublished) patent application 0116157.9 this "multiple bit shifting" is extended to the process of error trapping and error detection. Furthermore, it is suggested that these processes be carried out in a word-wise rather than byte-wise manner.

The word-wise CRC calculation includes two main steps, feedback word calculation and register content update. Assume that the number of taps is L and the word length is K. The feedback word consists the first K bits dropped out at left end of the circuit (see figure 1). The feedback word can be calculated recursively using the following equation:

$$fdbk\_word_n = fdbk\_word_{n-1} \oplus (fdbk\_word_{n-1} >> tap_1) \oplus (fdbk\_word_{n-1} >> tap_2).....$$

$$\oplus (fdbk\_word_{n-1} >> tap_L)$$

$$n = 1,2,3.....N \qquad\qquad [1]$$

taking the example of a decoder:

$$fdbk\_word_0 = current\_syndrome\_word,$$

In the foregoing, $syndrome\_word$ is the existing contents of the shift register and $tap_x$ can be determined as the difference between the order of the corresponding tap and the highest order of the generator polynomial.

For example, given a generator polynomial, $G(X) = X^6 + X^5 + X^3 + X^2 + X^1 + 1$, the tap positions, $tap_{0-6}$ are determined as:

Tap0=0 (corresponds to $X^6$), Tap1=1 (corresponds to $X^5$)
Tap2=3 (corresponds to $X^3$), Tap3=4 (corresponds to $X^2$)
Tap4=5 (corresponds to $X^1$), Tap5=6, (corresponds to $X^5$)

The number of recursions ($N$) can be determined using the following equation:

$$N = (K-1)/tap_1 \qquad\qquad [2]$$

After obtaining the feedback word, the syndrome word can be updated using the following formula:

$$new\_sydrome = next\_word \oplus [fdbk\_word <<(K-tap_1)] \oplus [fdbk\_word <<(K-tap_2)] .....$$

$$[fdbk\_word<<(K\text{-}tap_L)] \hspace{6cm} [3]$$

As the following calculations will show, if the CRC codec has a large number of feedback taps, the calculation of the feedback word could be time consuming and complicated, and also take up a lot of processing power. Thus, it would be advantageous if this process could be made faster.

The present invention provides a method of calculating a carryout word of length K from a cyclic shift register as described in claim 1. The expression "carryout word of length K" refers to the next K bits output from the shift register. In the case of an encoder or error trapping circuit the carryout word will be the feedback word used to up-date the content of the shift register. In the case of an encoder, the next K bits of the input binary sequence are modulo 2 added to the carryout word to form a feedback word (see claim 4).

In fact the definitions "encoder" and "decoder" are somewhat arbitrary since it can be demonstrated that the two shift registers are mathematically equivalent, see Lin/Costello "Error Control Coding: Fundamentals and Applications" Prentice Hall 1983, pages 100 and 101, figs 4.6 and 4.7.

Since the select_word depends only on the generator polynomial, it can be calculated separately (e.g. offline) and stored, and this represents a significant saving in processing power and hence time. The top_word_matrix on the other hand needs to be calculated from the input binary data.

Preferred features of the invention are described in the subsidiary claims.

An embodiment of the invention will now be described by way of example only and with reference to the accompanying drawings in which:

Figure 1(a) shows a typical CRC (cyclic redundancy check) encoder with generator polynomial

$$G(X) = X^3 + X + 1;$$

Figure 1(b) shows a CRC decoder corresponding to the encoder of figure 1(a);
Figure 1(c) shows an error trapping circuit corresponding to figure (b); and
Figure 2 shows an example of bit-wise CRC calculation by way of background.

### *Example 1:*

This example demonstrates the working principle of a Byte-Wise (*K*=8) CRC decoder with reference to figure 2. As noted above, in a decoder the carryout word is the same as the feedback word and is thus referred to in the following as the feedback word.

Given the generator polynomial,

$$G(X) = X^6 + X^5 + X^3 + X^2 + X^1 + 1$$

and a received binary sequence :
10011101101101

As shown in figure 2, the 6-bit syndrome is calculated bit by bit to give the result 111101. The same syndrome can also be calculated using the byte-wise method:

### *Feedback byte calculation:*

Using the equation [2], the recursion number is calculated as,

Recursion_num= (8-1)/1=7

$$fdbk\_word_1 = fdbk\_word_0 \oplus (fdbk\_word_0 >> 1) \oplus (fdbk\_word_0 >> 3) \oplus (fdbk\_word_{n-1} >> 4)$$
$$\oplus (fdbk\_word_o >> 5) \oplus (fdbk\_word_o >> 6)$$

$$= 10011101 \oplus 01001110 \oplus 00010011 \oplus 00001001 \oplus 00000100 \oplus 00000010$$

$$= 11001111$$

repeating the above calculation, the following results are obtained subsequently as:

$$fdbk\_word_2 = 10111000, \; fdbk\_word_3 = 11111111, \; fdbk\_word_4 = 10010100,$$

$$fdbk\_word_5 = 11000011, \; fdbk\_word_6 = 10110011, \; fdbk\_word_7 = 11110000$$

$$fdbk\_word = fdbk\_word_7 = 11110000$$

substituting the *fdbk_word* into equation [3]. The register content is updated as:

$$new\_register\_content = next\_word \oplus [fdbk\_word<<7] \oplus [fdbk\_word<<5] \oplus [fdbk\_word<<4]$$
$$\oplus \; [fdbk\_word<<3] \oplus [fdbk\_word<<2]$$

$$= 10110100 \oplus 00000000 \oplus 00000000 \oplus 00000000 \oplus 10000000 \oplus 11000000$$

$$= 11110100$$

The most significant 6 bits represent the new syndrome.
The result matches exactly the one shown in figure 2.
As shown in the above example, if a CRC codec consists a large number of feedback taps, the calculation of the carryout word could be rather complicated, and time-consuming. In order to speed up the run-time calculation of the feedback word, a new technique is invented, so that, the carryout word can be calculated in one step, rather than numbers of recursions.
In general the carryout word is a function of the top word (see figure 2), and their relationship can be described with the following equation

$$carryout\_word = select\_word \, . \, top\_word\_matrix \qquad [4]$$

where, carryout_word represents a 1x$K$ row vector ,containing $K$ feedback bits. Top_word_matrix is a KxK matrix which contain K right-shifted top words, as shown below,

$$\textbf{top\_word\_matrix} = \begin{bmatrix} \textbf{top\_word} \\ \textbf{top\_word} \gg 1 \\ \textbf{top\_word} \gg 2 \\ \vdots \\ \textbf{top\_word} \gg (K-1) \end{bmatrix} \qquad [5]$$

with the **top_word** representing a 1xK row vector.

The **select_word** is a constant 1x16 row vector that can be calculated off-line using the following equations:

$$\textbf{select\_word}_m = \textbf{generator\_polynormial\_word} \cdot \begin{bmatrix} \textbf{select\_word}_{m\text{-}1} \\ \textbf{select\_word}_{m\text{-}1} \gg 1 \\ \textbf{select\_word}_{m\text{-}1} \gg 2 \\ \vdots \\ \textbf{select\_word}_{m\text{-}1} \gg (K-1) \end{bmatrix} \qquad [6]$$

$$m=1,2,3.....M,$$

$$\text{select\_word}_0 = \text{generator\_polynomial\_word} \qquad [7]$$

M is the number of recursions required to evaluate the select word, it is calculated using the following equation:

$$M = ((K\text{-}1)/tap_1)\text{-}1 \qquad [8]$$

The **generator_polynomial_word** is also a 1x$K$ row vector representing the generator polynomial. For example, if $K$ equals 8 and the generator polynomial $G(X) = X^6 + X^5 + X^3 + X^2 + X^1 + 1$, the generator_polynomial_word is determined as [1 1 0 1 1 1 1 0].

### *Example 2*:

In the following example, the new technique presented above is applied, so that a byte-wise syndrome update can be completed in only one step:

Given the generator polynomial, $G(X) = X^6 + X^5 + X^3 + X^2 + X^1 + 1$ (as in example 1), the **generator_polynomial_word** is determined as [1 1 0 1 1 1 1 0].

Using Equation [6],[7] and [8], the select_word corresponding to this particular generator polynomial is calculated as follows:

$$M = ((8\text{-}1)/1)\text{-}1 = 6$$

$$\textbf{select\_word}_1 = [11011110] \cdot \begin{bmatrix} 11011110 \\ 01101111 \\ 00110111 \\ 00011011 \\ 00001101 \\ 00000111 \\ 00000011 \\ 00000001 \end{bmatrix} = [10100010]$$

subsequently,

$$\text{select\_word}_2 = [10100010], \text{ select\_word}_3 = [11101010], \text{ select\_word}_4 = [10001000],$$

$$\text{select\_word}_5 = [11100100],$$

and,

$$\text{select\_word} = \text{select\_word}_6 = [11100100].$$

Using the same received sequence as in example 1, 10011101101101, the feedback word can be calculated only in one step using equation [4].

$$\textbf{fdbk\_word} = [11100100] \cdot \begin{bmatrix} 10011101 \\ 01001110 \\ 00100111 \\ 00010011 \\ 00001001 \\ 00000100 \\ 00000010 \\ 00000001 \end{bmatrix} = [11110000]$$

The result shown above matches exactly the *fdbk_word* calculated in Example 1.

A novel technique has been presented which allows the feedback word or more generally a carryout word to be calculated in only one step with a pre-calculated select_word.

In Word-Wise CRC codecs, the feedback word would normally be calculated using a recursive operation. Such operation becomes complicated and time-consuming, if the codec has a large number of the feedback taps.

Considering a particular CRC codec, which has $P$ feedback taps, and the position of the first tap is $tap_1$, the number ($N$) of logic operations (including word-wise shift and XOR) required for the feedback word calculation is estimated as follows:

$$N = 2 \times P \times M = \frac{2 \times P \times M \, (K - 1)}{tap1}$$

with, $P \leq K, tap_1 \geq 1$, the maximal value of N is estimated as

$$N_{\max} = \frac{2 \times K \times (K - 1)}{1} = 2K(K - 1) \tag{9}$$

where, K is the word length. Assuming K is much larger than 1, it yields:

$$N_{max} \approx 2K^2 \tag{10}$$

On the other hand, if using the new technique, with equation [4], the maximum number of required logic operations, $N'_{max}$ is only,

$$N'_{max} = 2K, \tag{11}$$

in the worst situation, where the **select_word** contains only 1s.

As shown above, the new technique requires much less logic operations, Therefore by using this technique in a Word-Wise CRC codec, a significant improvement of the processing speed can be achieved.

**Claims**

1. A method of calculating a carryout word of length k from a cyclic shift register having feedback taps at positions determined by a generator polynomial, wherein the carryout word is calculated using the equation :

$$carryout\_word = select\_word \cdot top\_word\_matrix$$

wherein

$$\mathbf{top\_word\_matrix} = \begin{bmatrix} \mathbf{top\_word} \\ \mathbf{top\_word} \gg 1 \\ \mathbf{top\_word} \gg 2 \\ \vdots \\ \mathbf{top\_word} \gg (K-1) \end{bmatrix}$$

with the top_word comprising a 1xK row vector and wherein:

$$\mathbf{select\_word}_m = \mathbf{generator\_polynormial\_word} \cdot \begin{bmatrix} \mathbf{select\_word}_{m-1} \\ \mathbf{select\_word}_{m-1} \gg 1 \\ \mathbf{select\_word}_{m-1} \gg 2 \\ \vdots \\ \mathbf{select\_word}_{m-1} \gg (K-1) \end{bmatrix}$$

with $m$ = 1, 2, 3,.............M

and M = (K-1/$tap_1$)-1, wherein $tap_1$ is the difference between the orders of the highest and second highest order terms in the generator polynomial and >> represent shifts in the opposite direction to the shifting direction of the shift register.

2. A method as claimed in claim 1 in which the **select_word** is calculated from the generator polynomial and stored prior to the calculation of the carryout word.

3. A method as claimed in claim 1 or 2 for forming cyclic code words including modulo 2 adding the carryout word to the next K bits of an input binary sequence to form a feedback word, and applying the feedback word to the feedback taps of the shift register.

4. A method as claimed in claim 1 or claim 2 for encoding an input binary sequence in which the updated contents of the shift register are calculated from the formula:

$$fdbk\_word = carryout\_word \oplus \text{ next K bits of input binary sequence}$$

$$new\_register\_content =$$

$$[fdbk\_word << (K\_tap_1)] \oplus [fdbk\_word << (K\text{-}tap_2)]................$$

$$\oplus [fdbk\_word << (K\text{-}tap_L)]$$

in which L is the number of taps.

5. A method as claimed in claim 1 or claim 2 for calculating a syndrome form a cyclic code word in which a new syndrome is calculated from the formula:

$$new\_syndrome = next\_word \oplus [carryout\_word << (K\text{-}tap_1)] \oplus$$

$$[carryout\_word << (K\text{-}tap_2)]....[carryout\_word << (K\text{-}tap_L)]$$

in which *next_word* is the next K bits of the cyclic code word to be input to the shift register and L is the number of taps.

6. Use of the method of claim 1 or claim 2 for up-dating the contents of an error trapping circuit in which the new register content is calculated using the formula:

$$new\_register\_content = [carryout\_word << (K\text{-}tap_1)] \oplus [carryout\_word << (K\text{-}tap_2)]$$

$$\oplus....... \oplus [carryout\_word(K\text{-}tap_L)]$$

where L is the number of taps.

(a)

(b)

(c)

Figure 1. CRC Codec with generator polynomial $G(X)=X^3+X+1$,
(a) CRC encoder, (b) CRC decoder, (c) error trapping circuit

Figure 2. Bit-wise CRC calculation for example 1